# EUROPEAN PATENT APPLICATION

(11) **EP 4 635 932 A1**
(43) Date of publication of application: **22.10.2025**
(21) Application number: 25163430.9
(22) Date of filing: 13.03.2025
(51) Int. Cl.: C04B 35/573, C04B 35/626, C04B 35/80

(54) **CHEMICAL VAPOR DEPOSITION (CVD) AFTER HEATREATMENT FOR IMPROVED SILICON MELT INFILTRATION PROCESSING**

(30) Priority: 15.03.2024 US 202418607042
(71) Applicant: Goodrich Corporation, Charlotte, NC 28217-4578 (US)
(72) Inventor: KIRKPATRICK, Christopher T., Pueblo West, 81007 (US)
(74) Representative: Dehns

(57) **Abstract**

A method of fabricating a composite component is provided. The method includes forming a fibrous preform, performing a first densification on the fibrous preform to generate a densified fibrous preform, heat treating the densified fibrous preform to form a heat treated densified fibrous preform, performing a second densification on the heat treated densified fibrous preform, and performing a silicon melt infiltration after densifying the heat treated densified fibrous preform to form the composite component.

## Description

### FIELD

The present disclosure relates to composites, and more specifically, to improving silicon melt infiltration (SMI) processing of fiber reinforced composite components by performing an additional chemical vapor deposition (CVD)/chemical vapor infiltration (CVI) process after heat treating initial CVD/CVI processed fiber reinforced composite components.

### BACKGROUND

Aircrafts typically utilize brake systems on wheels to slow or stop the aircraft during landings, taxiing, and rejected takeoffs. Aircraft brake systems generally employ a brake stack (also referred to as a heat sink) including a series of friction disks that may be forced into contact with one another during braking to slow or stop the aircraft. The heat sink typically includes rotor disks and stator disks that, in response to axial compressive pressure, convert the kinetic energy of the aircraft into heat through frictional forces experienced between the friction disks. Heat sinks including carbon fiber carbon matrix composite (C/C) components and/or carbon fiber ceramic matrix composite (CMC) components may prove advantageous in addressing frictional and wear performance.

### SUMMARY

A method of fabricating a composite component, the method includes forming a fibrous preform, performing a first densification on the fibrous preform to generate a densified fibrous preform, heat treating the densified fibrous preform to form a heat treated densified fibrous preform, performing a second densification on the heat treated densified fibrous preform, and performing a silicon melt infiltration after densifying the heat treated densified fibrous preform to form the composite component.

In various embodiments, the first densification is performed for between 50 hours and 400 hours at between 900°F (482.2°C) and 1200°F (648.9°C).

In various embodiments, the heat treating is performed for between 2 hours and 20 hours at between 1300°F (704.4°C) and 2200°F (1204°C).

In various embodiments, the second densification is performed for between 50 hours and 400 hours at between 900°F (482.2°C) and 1200°F (648.9°C).

In various embodiments, the method further includes, after the second densification and prior to the silicon melt infiltration, machining the heat treated densified fibrous preform to form a final desired part shape of the composite component.

In various embodiments, performing the first densification on the fibrous preform generates a carbon matrix within the densified fibrous preform.

In various embodiments, the heat treating of the densified fibrous preform generates one or more cracks in the carbon matrix.

In various embodiments, performing the second densification on the heat treated densified fibrous preform seals the one or more cracks in the carbon matrix.

In various embodiments, sealing the one or more cracks reduces bending or warping of the composite component.

In various embodiments, performing the second densification on the heat treated densified fibrous preform maintains dimensional tolerances and strength of the composite component and reducing over-conversion of the carbon matrix to silicon carbide.

Also disclosed herein is a method of forming a fibrous preform for fabricating a composite component. The method includes forming a first ceramic particle layer over a first textile layer, disposing a second textile layer over the first ceramic particle layer, forming a second ceramic particle layer over the second textile layer, disposing a third textile layer over the second ceramic particle layer, performing a first densification on the fibrous preform to generate a densified fibrous preform, heat treating the densified fibrous preform to form a heat treated densified fibrous preform, performing a second densification on the heat treated densified fibrous preform, and performing a silicon melt infiltration after densifying the heat treated densified fibrous preform to form the composite component.

In various embodiments, the first densification is performed for between 50 hours and 400 hours at between 900°F (482.2°C) and 1200°F (648.9°C).

In various embodiments, the heat treating is performed for between 2 hours and 20 hours at between 1300°F (704.4°C) and 2200°F (1204°C).

In various embodiments, the second densification is performed for between 50 hours and 400 hours at between 900°F (482.2°C) and 1200°F (648.9°C).

In various embodiments, the method further includes, after the second densification and prior to the silicon melt infiltration, machining the heat treated densified fibrous preform to form a final desired part shape of the composite component.

In various embodiments, performing the first densification on the fibrous preform generates a carbon matrix within the densified fibrous preform.

In various embodiments, the heat treating of the densified fibrous preform generates one or more cracks in the carbon matrix.

In various embodiments, performing the second densification on the heat treated densified fibrous preform seals the one or more cracks in the carbon matrix.

In various embodiments, sealing the one or more cracks reduces bending or warping of the composite component.

In various embodiments, performing the second densification on the heat treated densified fibrous preform maintains dimensional tolerances and strength of the composite component and reducing over-conversion of the carbon matrix to silicon carbide.

The foregoing features and elements may be combined in various combinations without exclusivity, unless expressly indicated herein otherwise. These features and elements as well as the operation of the disclosed embodiments will become more apparent in light of the following description and accompanying drawings.

### BRIEF DESCRIPTION OF THE DRAWINGS

FIG. 1 illustrates a multi-disk brake assembly, in accordance with various embodiments.
FIG. 2 illustrates a fibrous preform including ceramic particle layers interspersed between fiber layers, in accordance with various embodiments.
FIG. 3 illustrates a plate for facilitating formation and densification of a fibrous preform having ceramic particle layers interspersed between fiber layers, in accordance with various embodiments.
FIGS. 4A, 4B, 4C, and 4D illustrate formation of a fibrous preform including ceramic particle layers, in accordance with various embodiments.
FIG. 5A illustrates a cross-section view of a fibrous preform after densification and silicon melt infiltration, in accordance with various embodiments.
FIG. 5B illustrates a magnified view of portion of a first cycle densified fiber-reinforced composite component of FIG. 5A after heat treatment, in accordance with various embodiments.
FIG. 5C illustrates a magnified view of portion of a second cycle densified fiber-reinforced composite component of FIG. 5B is illustrated, in accordance with various embodiments.
FIG. 5D illustrates a magnified view of a portion of a silicon melt infiltrated composite component is illustrated, in accordance with various embodiments.
FIG. 6 illustrates a method of fabricating a composite component, in accordance with various embodiments.

The subject matter of the present disclosure is particularly pointed out and distinctly claimed in the concluding portion of the specification. A more complete understanding of the present disclosure, however, may best be obtained by referring to the detailed description and claims when considered in connection with the drawing figures, wherein like numerals denote like elements.

### DETAILED DESCRIPTION

The detailed description of exemplary embodiments herein makes reference to the accompanying drawings, which show exemplary embodiments by way of illustration. While these exemplary embodiments are described in sufficient detail to enable those skilled in the art to practice the disclosure, it should be understood that other embodiments may be realized and that logical changes and adaptations in design and construction may be made in accordance with this disclosure and the teachings herein without departing from the spirit and scope of the disclosure. Thus, the detailed description herein is presented for purposes of illustration only and not of limitation.

Typically, fiber reinforced composite components and fabrication of fiber reinforced composite components, such as brake disks, having ceramic particle layers interspersed between fiber layers. The fabrication process of such brake disks may utilize silicon melt infiltration (SMI) (also referred to as reaction bonding) to provide benefits, such as higher density, higher strength, and better oxidation protection. However, issues may occur during the SMI. Specifically, issues may occur with a carbon and silicon exothermic reaction during the SMI process that forms silicon carbide (SiC). Accordingly, bending or warping, among other issues, of the brake disks may occur if too much of the base portion, i.e. carbon fibers, of the brake disk is consumed during the carbon and silicon exothermic reaction. If carbon fibers are overly consumed, then the benefits of the SMI are reduced.

Provided herein, according to various embodiments, are fiber reinforced composite components and method(s) for fabricating fiber reinforced composite components that improve silicon melt infiltration (SMI) processing by performing an additional chemical vapor deposition (CVD)/chemical vapor infiltration (CVI) process after heat treating initial CVD/CVI processed fiber reinforced composite components. In various embodiments, a single cycle of CVI/CVD deposition in a carbon fiber preform creates a carbon matrix. In various embodiments, the fiber reinforced composite components are then heat treated. In various embodiments, the heat treatment tends to create cracks in the CVD/CVI and between carbon fibers and carbon matrix. In various embodiments, these cracks may provide pathways to the edges of the CVD/CVI matrix for silicon to consume both the carbon matrix created by the CVD/CVI as well as the carbon fibers, which may cause bending or warping, among other issues, and thus strength reduction. In various embodiments, after the heat treatment, a second cycle of CVD/CVI deposition is performed that seals cracks and edge sites to protect the carbon fiber from silicon attack and to protect the CVD/CVI matrix from over converting to silicon carbide (SiC). In various embodiments, the second cycle of CVD/CVI deposition after the heat treatment provides for the fiber reinforced composite components to maintain dimensional tolerances and strength as well as reducing the over-conversion of the CVD/CVI matrix to SiC.

While numerous details are included herein pertaining to aircraft components, such as brake components, the components and method(s) disclosed herein can be applied to fabricate other carbon fiber-reinforced/carbon matrix composite (C/C) components that benefit from maintaining dimensional tolerances and strength as well as reducing the over-conversion of the CVD/CVI matrix to SiC.

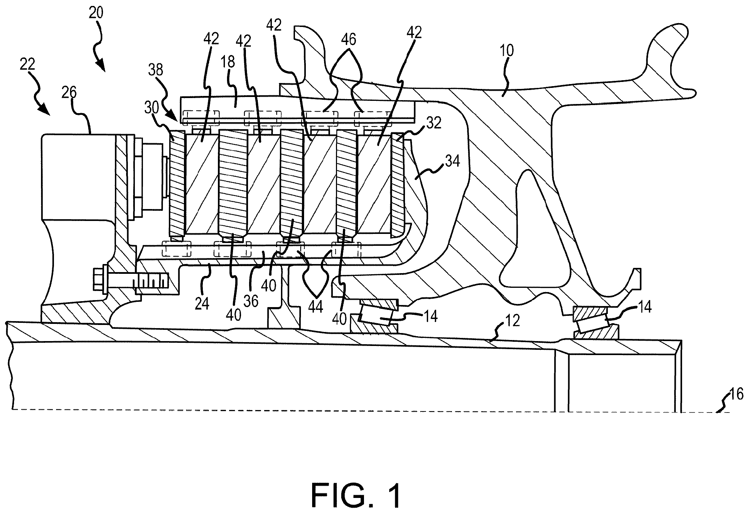

With reference to FIG. 1, a multi-disk brake assembly 20 is illustrated, in accordance with various embodiments. Multi-disk brake assembly 20 is mounted on an axle 12 for use with a wheel 10 disposed on and configured to rotate about the axle 12 via one or more bearing assemblies 14. A central axis 16 extends through the axle 12 and defines a center of rotation of the wheel 10. A torque tube 24 (sometimes referred to as a torque plate barrel or a torque plate) is aligned concentrically with the central axis 16. Wheel 10 is rotatable relative to the torque tube 24. Torque tube 24 includes a series of axially extending stator splines 36 (one shown). Wheel 10 includes a series of axially extending rotor splines 18 (one shown). Rotation of wheel 10 is modulated by multi-disk brake assembly 20.

Multi-disk brake assembly 20 includes a plurality of brake disks 38. The plurality of brake disks 38 includes at least one non-rotatable friction disk 40 (also referred to as a stator disk), and at least one rotatable friction disk 42 (as referred to as a rotor disk). Each of the brake disks 38 includes an attachment structure. For example, each of the stator disks 40 includes a plurality of stator lugs 44 at circumferentially spaced positions around an inner circumference of the stator disk 40, and each of the rotor disks 42 includes a plurality of rotor lugs 46 at circumferentially spaced positions around an outer circumference of the rotor disk 42.

Brake disks 38 may also include an end plate 32 and a pressure plate 30. end plate 32 and pressure plate 30 are located on opposing axial ends of the brake disk stack relative to one another. End plate 32 is connected to, or is otherwise frictionally engaged with, a reaction plate 34 of torque tube 24. End plate 32 is non-rotatable by virtue of its connection to torque tube 24. Stator splines 36 may support pressure plate 30 such that pressure plate 30 is also non-rotatable. Stator splines 36 may also support non-rotatable stator disks 40. Stator splines 36 are located in gaps formed between the stator lugs 44 of the stator disk 40. Similarly, rotor splines 18 gaps formed between the rotor lugs 46 of the rotor disk 42. Rotor disks 42 may be rotatable by virtue of their engagement with rotor splines 18 of wheel 10.

An actuating mechanism for the multi-disk brake assembly 20 includes a plurality of piston assemblies 22 (one shown) circumferentially spaced around a piston housing 26. Upon actuation, the plurality of piston assemblies 22 affects a braking action by urging pressure plate 30, stator disks 40, and end plate 32 into frictional engagement with the rotor disks 42. Through compression of the plurality of rotor disks 42 and the plurality of stator disks 40 between the pressure plate 30 and the end plate 32, the resulting frictional contact slows or stops or otherwise prevents rotation of the wheel 10.

In various embodiments, one or more of the friction disks (e.g., rotor disks 42, stator disks 40, pressure plate 30, end plate 32) are fabricated from composite materials, such as, for example, C/C and/or CMC, which enables the brake disks to withstand and dissipate the heat generated during and following a braking action. In various embodiments, the non-rotating frictional components of multi-disk brake assembly 20 (i.e., pressure plate 30, end plate 32, and stator disks 40) may comprise a material that is different from the material of the rotating frictional component (e.g., rotor disks 42). For example, in various embodiments, rotor disks 42 comprise C/C and pressure plate 30, end plate 32, and/or stator disks 40 may comprise CMC. In various embodiments, rotor disks 42 and/or stator disks 40 may comprise a core made of a first material (e.g., CMC) and wear liners attached to the core that are made of a second, different material (e.g., C/C).

In accordance with various embodiments, one or more of the friction disks are comprised of a C/C material having high specific heat particles interspersed throughout the friction disk, where high specific heat particles includes any particle or powder (typically ceramic) that raises the specific heat of the disk above that of C/C alone. For example, in various embodiments, the friction disk may comprise a C/C that includes a percentage of boron, boron carbide (B₄C), a boron component, or other material having a high specific heat *(i.e.,* a specific heat greater than the specific heat of the C/C alone).

As described in further detail below, the process of interspersing the boron carbide (or other high specific heat particles) into the C/C is performed by depositing a ceramic powder (e.g., boron carbide powder) between one or more fiber layers of the fibrous preform used to form the friction disk. In accordance with various embodiments, the ceramic powder may comprise a mix of difference size ceramic particles. After forming the fibrous preform, including one or more layers of ceramic particles, the fibrous preform is densified using chemical vapor infiltration (CVI) and/or chemical vapor deposition (CVD). During densification, a matrix material (e.g., a carbon matrix) is deposited on and encapsulates the ceramic particles and the fibers of the fiber layers. In various embodiments, after densification, a silicon melt infiltration is performed to form a silicon layer over the carbon matrix. Depositing ceramic powder between the fiber layers may allow greater volumes of high specific heat particles to be included in the composite part. Increasing the volume of high specific heat particles may decrease a porosity and/or increase a density of the final composite component. Further, greater volumes of high specific heat particles may reduce the volume of silicon material in the final composite component and/or may increase the specific heat of the final composite component.

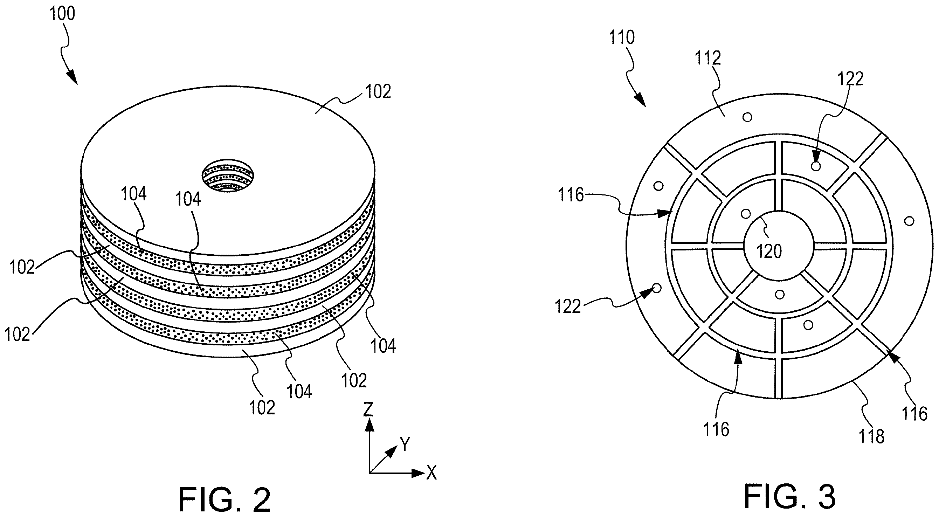

Referring now to FIG. 2, a fibrous preform 100 is illustrated, in accordance with various embodiments. Fibrous preform 100 may be employed to form a friction disk, as described above. Fibrous preform 100 may comprise a plurality of stacked fiber layers 102. Each fiber layer 102 has a first dimension in the axial, or "Z", direction that may be substantially less than the dimensions of the fiber layer 102 in the radial and circumferential directions. As used herein, the term "axial" refers to directions parallel with central axis 16 in FIG. 1 (e.g., parallel to the Z-axis on the provided X-Y-Z axes). As used herein, the term "radial" refers to directions perpendicular to central axis 16 in FIG. 1 (e.g., directions parallel to a plane formed by the X-axis and the Y-axis). For example, a first component that is radially outward of a second component is located a greater distance from central axis 16 as compared to the second component. As used herein, the term "circumferential" refers to directions about central axis 16 in FIG. 1 (e.g., directions about the Z-axis).

In accordance with various embodiments, fiber layers 102 comprises woven, braided, or knitted carbon fibers. In various embodiments, one or more of the fiber layers 102 may comprise carbon fibers in an open weave pattern (i.e., a weave wherein there is increased distance between the warp tows and between the weft tows). In various embodiments, each fiber layer 102 is between 15% and 95% open area. As used herein "open area" refers to the area that does not include carbon fibers. For example, a fiber layer 102 having 25% open area means 75% of the total area of the fiber layer 102 is carbon fiber. In various embodiments, fiber layer 102 is between 25% and 75% open area. In various embodiments, fiber layer 102 is between 25% and 50% open area. In various embodiments, the open area may vary between fiber layers 102. In this regard, a first fiber layer 102 may include a first open area and a second fiber layer 102 may include a second open area that is different from the first opening area. Employing open weave patterns tends to make fiber layer 102 generally easier to shape.

In various embodiments, one or more of the fiber layers 102 may comprise stretch-broken carbon fibers. Employing stretch-broken carbon fibers tends to increase the bonding or securing of the ceramic particles (e.g., B₄C powder) within the fiber layer and the composite part. In various embodiments, the carbon fibers may be derived from polyacrylonitrile (PAN), rayon (synthetic fiber derived from cellulose), oxidized polyacrylonitrile fiber (OPF), carbon pitch, or the like. The starting fiber may be pre-oxidized PAN or fully carbonized commercial carbon fiber. The fiber layers 102 may be formed or cut having any desired shape or form. For example, the fiber layers 102 may have any shape such as, for example, a polygon, circular, triangle, square, rectangle, pentagon, hexagon, octagon, or any other desired shape. In various embodiments, fiber layers 102 and fibrous preform 100 may have a generally annular shape. In various embodiments, fiber layers 102 and fibrous preform 100 may have a generally annular shape with protrusions extending radially outward from the outer circumferential surface. In various embodiments, fiber layers 102 and fibrous preform 100 may have a generally annular shape with protrusions extending radially inward from the inner circumferential surface.

In accordance with various embodiments, fibrous preform 100 includes one or more ceramic particle layers 104. Each ceramic particle layer 104 is located between a pair of adjacent fiber layers 102. In various embodiments, ceramic particle layers 104 may be comprised of boron carbide particles. A range of particle sizes (or powder sizes) may be employed in the ceramic powders used to fabricate the ceramic particle layers 104. For example, in various embodiments, a boron carbide powder between 10 grit and 400 grit may be selected for ceramic particle layers 104. In various embodiments, a boron carbide powder between 100 grit and 400 grit may be selected for ceramic particle layers 104. In various embodiments, a boron carbide powder between 100 grit and 320 grit may be selected for ceramic particle layers 104. In various embodiments, a 240 grit boron carbide powder may be used to form ceramic particle layers 104. Stated differently, the boron carbide particles may have an average particle size between about 22 micrometers (µm) and about 1854 µm, between about 22 µm and about 122 µm, between about 31 µm and about 122 µm, and/or about 51 µm (i.e., between about 0.00047 inches and about 0.073 inches, between about 0.00047 inches and about 0.0048 inches, between about 0.00122 inches and about 0.0048 inches, and/or about 0.0020 inches). As used in the previous context only, the term "about" means plus or minus ten percent of the associated value.

In various embodiments, one or more of the ceramic particle layer 104 may include a mixture of particle sizes. In various embodiments, the ceramic particle layer 104 comprises a first group of ceramic particles (e.g., B₄C particles) having a first average particle size and a second group of particles having a second average particle size greater than the first average particle size. In various embodiments, the ceramic particles of the first group may have a first average particle size between 20 grit and 180 grit, between 20 grit and 100 grit, between 50 grit and 100 grit, or between 50 grit and 60 grit. Stated differently, the first group of ceramic particles (e.g., B₄C particles) may have a first average particle size between 1.0 mm and 82.0 µm (between 0.039 inches and 0.003 inches), between 1.0 mm and 162.0 µm (between 0.039 inches and 0.006 inches), between 336.0 µm and 162.0 µm (between 0.013 inches and 0.006 inches), or between 336.0 µm and 269.0 µm (between 0.013 inches and 0.011 inches).

In various embodiments, the ceramic particles of the second group have a second average particle size between 100 grit and 400 grit, between 100 grit and 320 grit, or between 120 grit and 240 grit. Stated differently, the second group of ceramic particles (e.g., B₄C particles) may have a second average particle size between 162.0 µm and 35.0 µm (between 0.006 inches and 0.001 inches), between 162.0 µm and 46.2 µm (0.006 inches and 0.0018 inches), or between 125 µm and 58.5 µm (0.005 inches and 0.0023 inches).

In various embodiments, the ceramic particles of the first average particle size (i.e., the larger particle size) form a larger weight percentage of particle mixture as compared to the weight percentage formed by the ceramic particles of the second average size. For example, the ceramic particle mixture of one or more of the ceramic particle layer(s) 104 may comprise from 55% to 95% by weight ceramic particles having the first average particle size and from 45% to 5% by weight ceramic particles having the second average particle size. In various embodiments, the ceramic particle mixture of one or more of the ceramic particle layer(s) 104 may comprise from 70% to 90% by weight ceramic particles having the first average particle size and from 30% to 10% by weight ceramic particles having the second average particle size. In various embodiments, the ceramic particle mixture of one or more of the ceramic particle layer(s) 104 may comprise from 80% to 90% by weight ceramic particles having the first average particle size and from 20% to 10% by weight ceramic particles having the second average particle size. In various embodiments, the ceramic particle layers 104 may include a mixture of ceramic powder and phenolic resin powder. The phenolic resin powder may form, for example, between 0.5% and 15%, between 1.0% and 10.0%, or between 2.0% and 8.0% by weight of the total ceramic-powder-phenolic-resin powder mixture. Phenolic resin powder tends to facilitate even distribution of the ceramic powder.

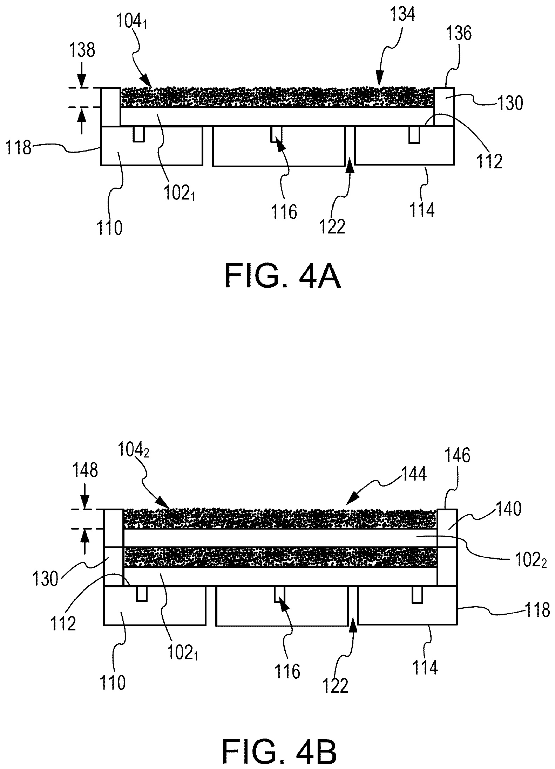

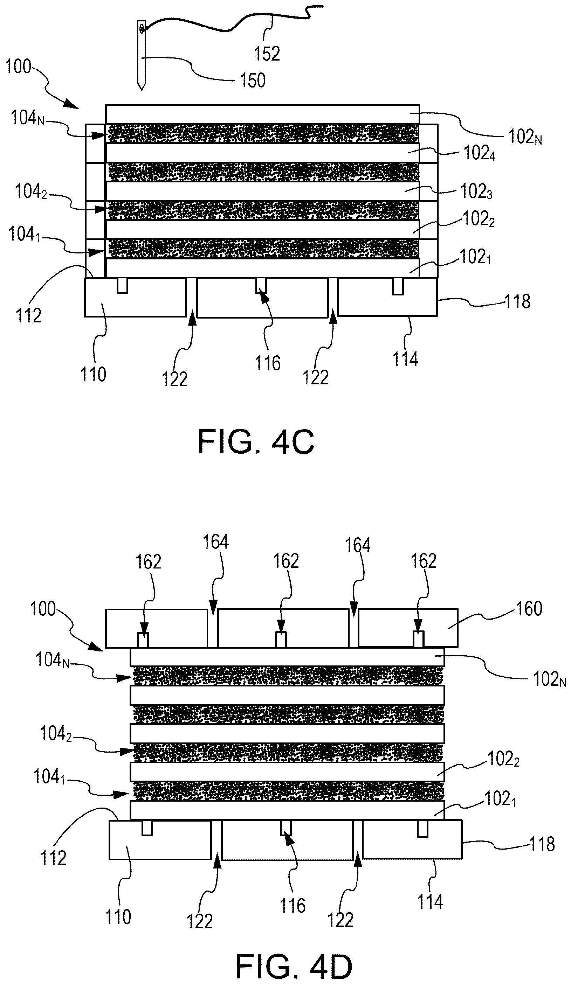

With reference to FIGS. 3, 4A, 4B, 4C, and 4D, formation of fibrous preform 100 is illustrated, in accordance with various embodiments. In FIG. 4A, a first fiber layer 102₁ is located on a plate 110. FIG. 3 illustrates plate 110, in accordance with various embodiments. With combined reference to FIGS. 3 and 4A, plate 110 includes opposing surfaces 112 and 114. First fiber layer 102₁ may be located on surface 112 of plate 110. A plurality of grooves, or channels, 116 may be formed into surface 112. Stated differently, surface 112 of plate 110 may define grooves 116. Grooves 116 may extend from an outer circumferential surface 118 and/or from an inner circumferential surface 120 of plate 110. In various embodiments, plate 110 may include one or more orifices 122 extending from surface 112 to surface 114. Grooves 116 and orifices 122 tend to facilitate the flow of gas into the fibrous preform during densification. Grooves 116 and orifices 122 may be formed in any desired pattern. While plate 110 is illustrated as having an annular shape, it is contemplated and understood that plate 110 may have any desired shape. In various embodiments, the shape of plate 110 matches the shape of fiber layers 102.

With continued reference to FIG. 4A, a first shim, or spacer, 130 is located around an outer perimeter (or outer circumference) 132 of first fiber layer 102₁. For fiber layers having an annular shape, a shim is also located along the inner perimeter (or inner circumference). With first shim 130 in place, boron carbide powder 134 is deposited (e.g., poured) over first fiber layer 102₁. The boron carbide powder 134 is deposited until, at least, an upper surface 136 of first shim 130 is reached (i.e., until the volume defined by first shim 130 and first fiber layer 102₁ is filled, or substantially filled, with boron carbide powder 134). In various embodiments, a scrapper or leveler may be translated (i.e., slid) over boron carbide powder 134 and first shim 130 to remove any portion of boron carbide powder 134 which may be extending beyond upper surface 136 of first shim 130. In this regard, after scraping, the boron carbide powder 134 forms a first ceramic particle layer 104₁ having a thickness 138.

With reference to FIG. 4B, a second fiber layer 102₂ is located over first ceramic particle layer 104₁. A second shim 140 is located over first shim 130 and around the outer perimeter of second fiber layer 102₂. For fiber layers 102 having an annular shape, a shim is also located along the inner perimeter (or inner circumference) of the fiber layer 102. With second shim 140 in place, ceramic powder 144 is deposited (e.g., poured) over second fiber layer 102₂. The ceramic powder 144 is deposited until at least an upper surface 146 of second shim 140 is reached (i.e., until the volume defined by second shim 140 and second fiber layer 102₂ is filled, or substantially filled, with ceramic powder 144). In various embodiments, a scrapper or leveler may be translated or slid over ceramic powder 144 and second shim 140 to remove any portion of ceramic powder 144 which may be extending beyond upper surface 146 of second shim 140. In this regard, after scraping, the ceramic powder 144 forms a second ceramic particle layer 104₂ having a thickness 148. Thickness 148 may be equal to thickness 138 (FIG. 4A). This process may be repeated until a desired number of fiber layers 102 and ceramic particle layers 104 is achieved (i.e., stacked).

With reference to FIG. 4C, once the desired number of fiber layers 102 and ceramic particle layers 104 have been formed (i.e., stacked), the fibrous preform 100 is needled. For example, a needle 150 may be used to weave a carbon fiber 152 between first fiber layer 102₁ and final fiber layer 102_{N}. In this regard, carbon fiber 152 may extend in the Z (or axial) direction between fiber layers 102. In another example, the needle 150 may brake fibers in first fiber layer 102_{N} and pull them through to through to the lower layers, e.g., further fiber layer 102₄, third fiber layer 102₃, second fiber layer 102₂, and first fiber layer 102₁. In various embodiments, a needling operation may be performed after each fiber layer 102 is stacked or at any desired interval. In this regard, the fibrous preform 100 may include Z-direction fibers of varying axial length. For example, one tow of Z-direction fibers may extend between the first fiber layer 102₁ and the second fiber layer 102₂, another tow of Z-direction fibers may extend between the first fiber layer 102₁ and the third fiber layer 102₃, another tow of Z-direction fibers may extend between the first fiber layer 102₁ and the final fiber layer 102_{N}, another tow of Z-direction fibers may extend between the final fiber layer 102_{N} and the second fiber layer 102₂, etc.

With reference to FIG. 4D, after needling, the shims are removed and a plate 160 is located over the final fiber layer 102_{N}. In this regard, plate 110 and plate 160 are located over opposing ends of fibrous preform 100. Plate 160 may include grooves 162 and/or orifices 164, similar to grooves 116 and orifices 122 in plate 110.

In accordance with various embodiments, a compressive load may be applied to fibrous preform 100. For example, in response to removing the shims, the weight of plate 160 may compress fibrous preform 100 between plate 110 and plate 160. In various embodiments, a compressive load may be applied to plate 160 to compress fibrous preform 100 between plate 110 and plate 160. In various embodiments, one or more clamps may be attached between plate 110 and plate 160. The clamps are configured to compress fibrous preform 100 between plate 110 and plate 160.

In various embodiments, the fibrous preform 100 and plates 110, 160 are then placed in a CVI/CVD furnace for densification for a first cycle. In various embodiments, the fibrous preform 100 and plates 110, 160 may be densified at temperatures between 900°F (482.2°C) and 1200°F (648.9°C). In various embodiments, the fibrous preform 100 and plates 110, 160 may be densified at temperatures between 950°F (510°C) and 1150°F (621.1°C). In various embodiments, the fibrous preform 100 and plates 110, 160 may be densified at temperatures between 1000°F (537.8°C) and 1100°F (593.3°C). In various embodiments, the fibrous preform 100 and plates 110, 160 may be densified between 50 hours and 400 hours. In various embodiments, the fibrous preform 100 and plates 110, 160 may be densified between 100 hours and 350 hours. In various embodiments, the fibrous preform 100 and plates 110, 160 may be densified between 150 hours and 300 hours.

In various embodiments, after densification (i.e., once a desired density and/or a desired volume of carbon matrix is achieved), the fibrous preform 100 and plates 110, 160 are heat treated. In various embodiments, the fibrous preform 100 and plates 110, 160 may be heat treated at temperatures between 1300°F (704.4°C) and 2200°F (1204°C). In various embodiments, the fibrous preform 100 and plates 110, 160 may be heat treated at temperatures between 1375°F (746.1°C) and 2000°F (1093°C). In various embodiments, the fibrous preform 100 and plates 110, 160 may be heat treated at temperatures between 1400°F (760°C) and 1800°F (982.2°C). In various embodiments, the fibrous preform 100 and plates 110, 160 may be heat treated between 2 hours and 20 hours. In various embodiments, the fibrous preform 100 and plates 110, 160 may be heat treated between 4 hours and 15 hours. In various embodiments, the fibrous preform 100 and plates 110, 160 may be heat treated between 6 hours and 10 hours. In various embodiments, the heat treatment tends to create cracks in the CVD/CVI and between carbon fibers and carbon matrix. In various embodiments, these cracks may provide pathways to the edges of the CVD/CVI matrix for silicon to consume both the carbon matrix created by the CVD/CVI as well as the carbon fibers, which may cause bending or warping, among other issues, and thus strength reduction.

In that regard, in various embodiments, the fibrous preform 100 and plates 110, 160 are then placed in a CVI/CVD furnace for densification for a second cycle. In various embodiments, the fibrous preform 100 and plates 110, 160 may be densified at temperatures between 900°F (482.2°C) and 1200°F (648.9°C). In various embodiments, the fibrous preform 100 and plates 110, 160 may be densified at temperatures between 950°F (510°C) and 1150°F (621.1°C). In various embodiments, the fibrous preform 100 and plates 110, 160 may be densified at temperatures between 1000°F (537.8°C) and 1100°F (593.3°C). In various embodiments, the fibrous preform 100 and plates 110, 160 may be densified between 50 hours and 400 hours. In various embodiments, the fibrous preform 100 and plates 110, 160 may be densified between 100 hours and 350 hours. In various embodiments, the fibrous preform 100 and plates 110, 160 may be densified between 150 hours and 300 hours. In various embodiments, the second cycle of CVD/CVI deposition seals cracks and edge sites to protect the carbon fiber from silicon attack and to protect the CVD/CVI matrix from over converting to SiC. In various embodiments, the second cycle of CVD/CVI deposition after the heat treatment provides for the fiber reinforced composite components to maintain dimensional tolerances and strength as well as reducing the over-conversion of the CVD/CVI matrix to SiC.

In various embodiments, there are a plurality of ceramic particle layers between the first ceramic particle layer 104₁ and a final ceramic particle layer 104_{N}. If, for instance, there are three ceramic particle layers, the first ceramic particle layer 104₁ and the final ceramic particle layer 104_{N} are outer layers with second ceramic particle layer 104₂ as a middle layer. The middle, or center, relative to the axial direction, of the disk may be composed of finer B₄C grit mixtures (e.g., grit sizes of approximately 240-400) whereas the outer surfaces may use courser grit size mixtures. For instance, a fine grit size may be a 220-400 grit size (e.g., particles with a diameter less than 60.0 microns (2362 microinches)), a medium grit size may be a 120-180 grit size (e.g., particles with a diameter between 60.0-100.0 microns (2362 - 3937 microinches)), and a course grit may be a 60-100 grit size (e.g., particles with a diameter greater than 100.0 microns (3937 microinches)), approximately. Using smaller sizes in the current CVD process, "self-limits" penetration of silicon. In other words, when the pores get small enough during the reaction between silicon and carbon during the melt infiltration process, the conversion process actually blocks off more or further infiltration. For instance, in a 300-hour CVD cycle, grit sizes of 240-400 tend to result in this "seal off". For instance, the pore size is reduced to zero (e.g., the pore is closed). Accordingly, smaller grit sizes may be used toward the center layer with larger grit sizes on the outside to tailor the depth of penetration. The full infiltration on the outer layer (e.g., 6.35 mm (0.25 inch)) can serve as oxidation protection while limiting the detrimental specific heat effect of the silicon throughout by varying the smallest grit size one gets to the center of the part. Accordingly, there is a relationship between the B₄C grit size and the number of hours of CVD. Based on the B₄C grit size and the number of hours of CVD, the penetration depth of the silicon may be controlled.

For example, if all the different grit mixtures (e.g., the first and second group of ceramic particles) comprise a coarser grit of 60 grit, the outside, or first ceramic particle layer 104₁, may have a 60 grit/120 grit mixture. For instance, the 60 grit/120 grit mixture may include 80% 60 grit and 20% 120 grit. Each ceramic particle layer may be 0.10 inches (i.e., 2.54 mm), where the following layer may be a 60 grit/150 grit combination (e.g., 80%/20%, respectively), followed by a 60 grit/180 grit combination (e.g., 80%/20%, respectively), and a 60 grit/240 grit (e.g., 80%/20%, respectively) at the center, or core, of the component such that the reaction forms pores that vary in size from larger to smaller. Typically, the outside densifies more readily than the inside because the pore network is the same throughout the part, but by varying the grit size combinations from outside to inside, the part can more uniformly densify because the smaller grit pickup CVD density more quickly, and thus also seal more quickly. As another example, the center may comprise a 60 grit and 400 grit combination, thereby resulting in no silicon infiltration in the core. A 60 grit/150 grit combination may be used on the outer surfaces so that penetration is limited to only where a coarser grit mixture is utilized. Further, the CVD run times coincide with the grit sizes and resulting porosity. In other words, as the CVD processing hours increase, the pore sizes decreases, thus allowing less silicon to penetrate.

In various embodiments, after the second cycle of CVD/CVI, a silicon melt infiltration (SMI) may be performed to fill, or substantially fill, any remaining porosity (e.g., any pores in the matrix material). In various embodiments, after the second cycle of densification and prior to SMI, fiber-reinforced composite component 100 may be machined to form the final desired part shape. The machining may also expose/open a fresh carbon surface. This fresh surface tends to be easier for molten silicon to wet-out. In this regard, machining the surfaces of the densified preform may allow the silicon to better wet the preform surfaces during SMI.

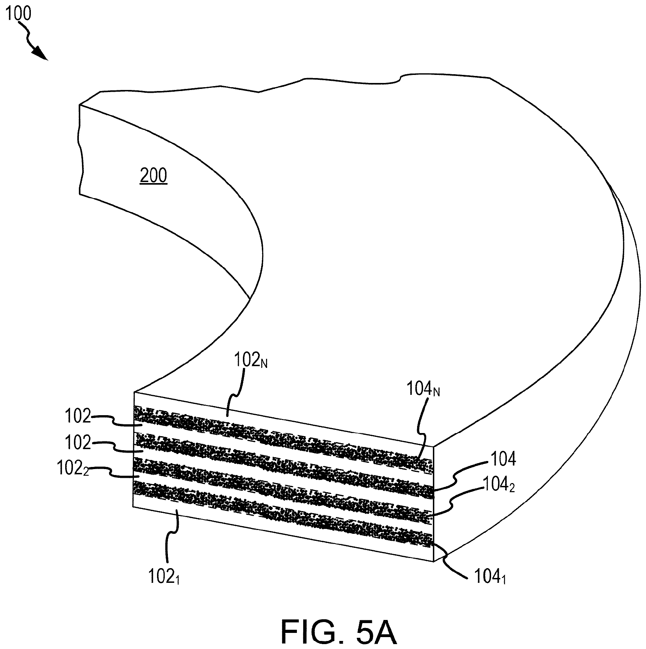

FIG. 5A illustrates a cross-section view of fibrous preform 100 after densification and SMI, in accordance with various embodiments. After densification, fibrous preform 100 forms a fiber-reinforced composite component 200. Stated differently, the densified and silicon infiltrated fibrous preform is a fiber-reinforced composite component. The porosity, or open space, between the carbon fibers of fiber layers 102 and between the ceramic particles of ceramic particle layers 104 is filled, or substantially filled, with carbon matrix. It is contemplated and understood that boron carbide particles may infiltrate and be located within the fiber layers 102.

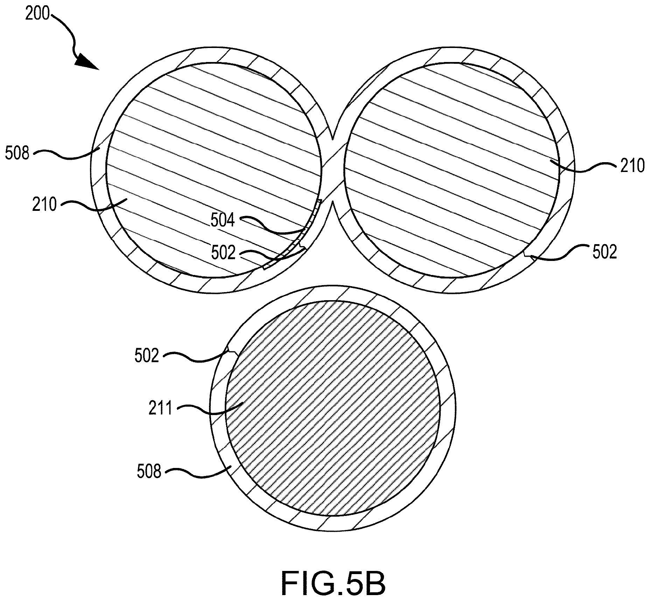

Referring now to FIG. 5B, a magnified view of portion of a first cycle densified fiber-reinforced composite component 200 of FIG. 5A after heat treatment is illustrated, in accordance with various embodiments. In various embodiments, heat treating the densified fiber-reinforced composite component 200 after the first cycle may create matrix cracks 502 and fiber/matrix interface cracks 504 in matrix material 508 generated during the first cycle of CVD/CVI, around and/or between adjacent carbon fibers 211, around and/or between adjacent boron carbide particles 210, or between the carbon fibers 211 and the boron carbide particles 210, among others. In various embodiments, the matrix cracks 502 and the fiber/matrix interface crack 504 may provide pathways to the edges of the matrix material 508 for silicon during silicon melt infiltration to consume both the matrix material 508 created by the CVD/CVI as well as the carbon fibers 211 and/or the boron carbide particles 210, which may cause bending or warping, among other issues, and thus strength reduction.

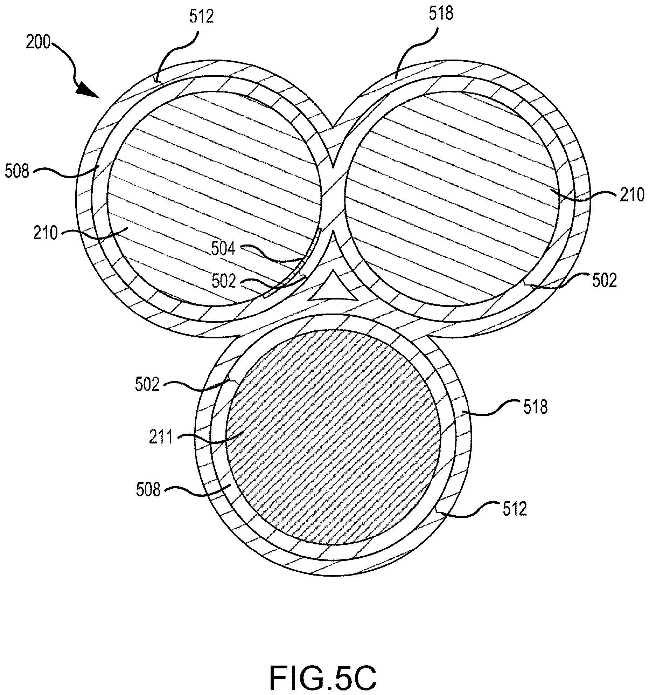

Referring now to FIG. 5C, a magnified view of portion of a second cycle densified fiber-reinforced composite component 200 of FIG. 5B is illustrated, in accordance with various embodiments. In various embodiments, the second cycle of densification may seal the matrix cracks 502 and the fiber/matrix interface crack 504 as well as create additional cracks 512 in generated matrix material 518. In various embodiments, by the matrix material 518 sealing the matrix cracks 502 and the fiber/matrix interface cracks 504, pathways to the edges of the matrix material 508 for silicon during silicon melt infiltration to consume both the matrix material 508 created by the CVD/CVI as well as the carbon fibers 211 and/or the boron carbide particles 210 are eliminated thus reducing or eliminating bending or warping, among other issues, and increasing strength. In various embodiments, cracks 512 do not provide pathways to the edges of the matrix material 518 due to matrix material 508 for silicon during silicon melt infiltration to consume both the matrix material 518 created by the CVD/CVI as well as the carbon fibers 211 and/or the boron carbide particles 210 thus, again, thus reducing or eliminating bending or warping, among other issues, and increasing strength.

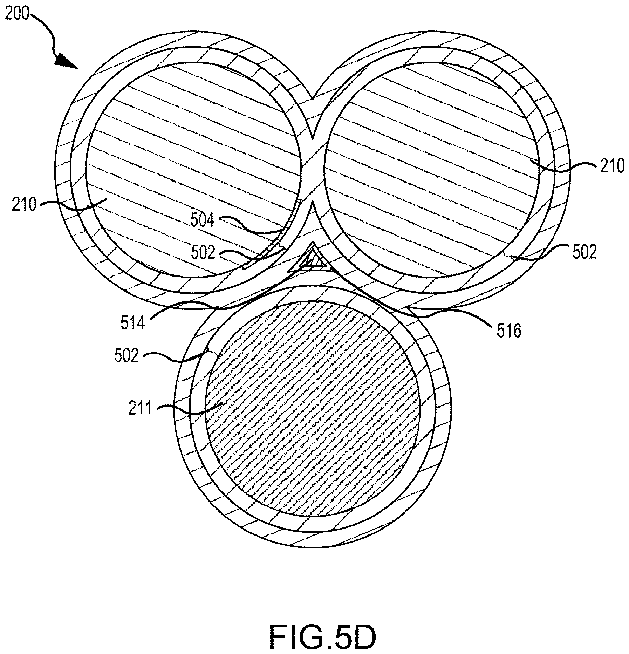

Referring now to FIG. 5D, a magnified view of a portion of a silicon melt infiltrated composite component 200 (i.e., fibrous preform 100 after a second cycle of densification) is illustrated, in accordance with various embodiments. In various embodiments, boron carbide particles 210 and carbon fibers 211 are coated and/or encapsulated with matrix materials (e.g., carbon layer) 508 and 518. Stated differently, the matrix materials 508 and 518 are located in the porosity (i.e., open volume) between adjacent boron carbide particles 210, between adjacent carbon fibers 211, and between adjacent boron carbide particles 210 and carbon fibers 211. During the silicon melt infiltration, silicon 514 infiltrates the porosity (i.e., open volume) in the matrix materials 508 and 518. However, the matrix material 518 blocks access of the silicon 514 to the carbide particles 210 and the carbon fibers 211 via the matrix cracks 502 and the fiber/matrix interface cracks 504 and the matrix material 508 blocks access of the silicon 514 to the carbide particles 210 and the carbon fibers 211 via the cracks 512. A layer of silicon carbide 516 may be formed at the interface between the silicon 514 and the carbon of the matrix materials 508 and 518. The silicon 514 and silicon carbide 516 coating over the matrix materials 508 and 518 and the boron carbide particles 210 tends to protect the boron carbide from moisture, which reduces the risk of boron trioxide (B₂O₃) formation, at increased temperatures, and/or subsequent boric acid formation. Decreasing boron trioxide (B₂O₃) and/or boric acid formation tends to reduce the material loss and/or the material recession associated with increased volumes of boron carbide. In various embodiments, the second cycle of densification, i.e. CVD/CVI deposition, seals the matrix cracks 502 and the fiber/matrix interface cracks 504 to protect boron carbide particles 210 and carbon fibers 211 from an exposure to attack by the silicon 514, thereby protecting the matrix materials 508 and 518 from over converting to silicon carbide 516. In various embodiments, the second cycle densification after the heat treatment provides for the fiber reinforced composite components to maintain dimensional tolerances and strength as well as reducing the over-conversion of the matrix materials 508 and 518 to silicon carbide 516.

In various embodiments, after the cycles of densification, fibrous preform 100 may have an open porosity of less than 15%, less than 10%, or less than 8%. In this regard, the open volume defined by the matrix material 212 may form less than 15%, less than 10%, or less than 8% of the total volume of densified fibrous preform 100. In various embodiments, after SMI, fiber-reinforced composite component 200 may have an open porosity of less than 2% or less than 1%. In this regard, the pores, or open volume, of fiber-reinforced composite component 200 may form less than 2% or less than 1% of the total volume of fiber-reinforced composite component 200. In various embodiments, the silicon material (e.g., the silicon 214 and the silicon in the silicon carbide 216) may form less than 10%, less than 8%, or less than 5% of a total weight of fiber-reinforced composite component 200.

In accordance with various embodiments, the volume of ceramic powder having the first average particle size and the second average particle size are selected such that a ratio of the weight of the ceramic powder to the weight of the silicon in the fiber-reinforced composite component 200 is at least 2.25:1. In various embodiments, the ratio of the weight of the ceramic powder to the weight of the silicon in the fiber-reinforced composite component 200 may be between 2.25:1 and 15:1, between 2.25:1 and 5:1, between 2.25:1 and 3:1, or between 2.25:1 and 2.5:1, and/or at least 2.3:1. A ratio of 2.25:1 or greater is associated with an increased specific heat of fiber-reinforced composite component 200, relative to C/C alone. Increasing the ratio of ceramic powder to silicon (e.g., B₄C to silicon) in fiber-reinforced composite component 200 tends to increase the specific heat of fiber-reinforced composite component 200. In this regard, the specific heat of fiber-reinforced composite component 200 may be tailored by increasing the volume ceramic powder and/or decreasing the volume of silicon. In various embodiments, fiber-reinforced composite component 200 may include, by weight percentage, between 30% and 90% boron carbide, between 40% and 80% boron carbide, and/or between 65% and 70% boron carbide. Fiber-reinforced composite component 200 may thus exhibit similar properties (e.g., strength, ductility, reduced crack propagation, etc.) to C/C alone, but with an increased specific heat. Stated differently, fiber-reinforced composite component 200 is a CMC material having a greater specific heat than C/C, while exhibiting the other properties of C/C.

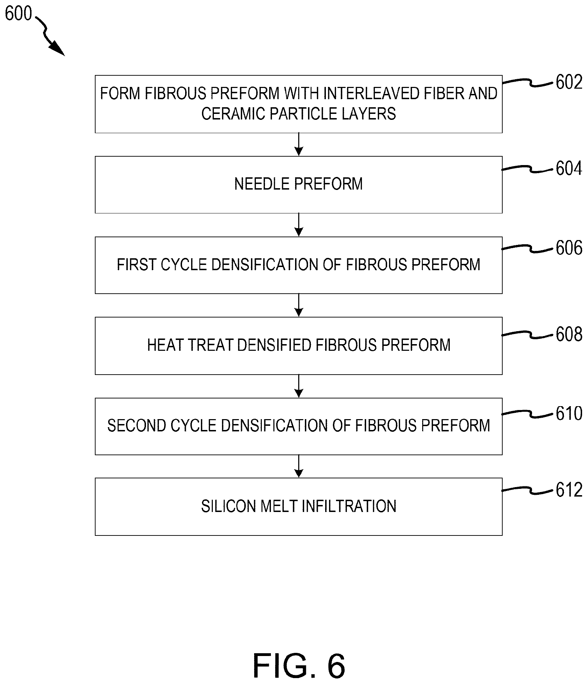

With refence to FIG. 6, a method 600 of fabricating a composite component is illustrated. In accordance with various embodiments, method 600 may include forming a fibrous preform (step 602), needling the fibrous preform (step 604), performing a first cycle of densification on fibrous preform (step 606), heat treating the fibrous preform (step 608), performing a second cycle of densification on fibrous preform (step 610), and performing a silicon melt infiltration (step 612). In various embodiments, a machining operation may be performed after the second cycle of densification (after step 610) and prior to the silicon melt infiltration (prior to step 612). In this regard, method 600 may include machining the densified fibrous preform to near net-shape (e.g., to a final desired part shape) prior to performing the silicon melt infiltration.

Accordingly, in various embodiments, performing an additional chemical vapor deposition (CVD)/chemical vapor infiltration (CVI) process after heat treating initial CVD/CVI processed fiber reinforced composite components improves silicon melt infiltration (SMI) thereby reducing or eliminating bending or warping, among other issues. Additionally, in various embodiments, performing an additional chemical vapor deposition (CVD)/chemical vapor infiltration (CVI) process after heat treating initial CVD/CVI processed fiber reinforced composite components reduces or eliminates conversion of carbon fiber into silicon carbide (SiC), which tends to reduce composite strength during SMI. Further, in various embodiments, performing an additional chemical vapor deposition (CVD)/chemical vapor infiltration (CVI) process after heat treating initial CVD/CVI processed fiber reinforced composite components increases oxidation protection because the base carbon gets fully coated and has a mostly continuous coating layer. In various embodiments, the second cycle of CVD/CVI deposition after the heat treatment provides for the fiber reinforced composite components to maintain dimensional tolerances and strength as well as reducing the over-conversion of the CVD/CVI matrix to SiC.

Benefits, other advantages, and solutions to problems have been described herein with regard to specific embodiments. Furthermore, the connecting lines shown in the various figures contained herein are intended to represent exemplary functional relationships and/or physical couplings between the various elements. It should be noted that many alternative or additional functional relationships or physical connections may be present in a practical system. However, the benefits, advantages, solutions to problems, and any elements that may cause any benefit, advantage, or solution to occur or become more pronounced are not to be construed as critical, required, or essential features or elements of the disclosure.

The scope of the disclosure is accordingly to be limited by nothing other than the appended claims, in which reference to an element in the singular is not intended to mean "one and only one" unless explicitly so stated, but rather "one or more." It is to be understood that unless specifically stated otherwise, references to "a," "an," and/or "the" may include one or more than one and that reference to an item in the singular may also include the item in the plural. All ranges and ratio limits disclosed herein may be combined.

Moreover, where a phrase similar to "at least one of A, B, and C" is used in the claims, it is intended that the phrase be interpreted to mean that A alone may be present in an embodiment, B alone may be present in an embodiment, C alone may be present in an embodiment, or that any combination of the elements A, B and C may be present in a single embodiment; for example, A and B, A and C, B and C, or A and B and C. Different cross-hatching is used throughout the figures to denote different parts but not necessarily to denote the same or different materials.

The steps recited in any of the method or process descriptions may be executed in any order and are not necessarily limited to the order presented. Furthermore, any reference to singular includes plural embodiments, and any reference to more than one component or step may include a singular embodiment or step. Elements and steps in the figures are illustrated for simplicity and clarity and have not necessarily been rendered according to any particular sequence. For example, steps that may be performed concurrently or in different order are illustrated in the figures to help to improve understanding of embodiments of the present disclosure.

Any reference to attached, fixed, connected or the like may include permanent, removable, temporary, partial, full and/or any other possible attachment option. Additionally, any reference to without contact (or similar phrases) may also include reduced contact or minimal contact. Surface shading lines may be used throughout the figures to denote different parts or areas but not necessarily to denote the same or different materials. In some cases, reference coordinates may be specific to each figure.

Systems, methods, and apparatus are provided herein. In the detailed description herein, references to "one embodiment," "an embodiment," "various embodiments," etc., indicate that the embodiment described may include a particular feature, structure, or characteristic, but every embodiment may not necessarily include the particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to affect such feature, structure, or characteristic in connection with other embodiments whether or not explicitly described. After reading the description, it will be apparent to one skilled in the relevant art(s) how to implement the disclosure in alternative embodiments.

Furthermore, no element, component, or method step in the present disclosure is intended to be dedicated to the public regardless of whether the element, component, or method step is explicitly recited in the claims. No claim element is intended to invoke 35 U.S.C. 112(f) unless the element is expressly recited using the phrase "means for." As used herein, the terms "comprises," "comprising," or any other variation thereof, are intended to cover a non-exclusive inclusion, such that a process, method, article, or apparatus that comprises a list of elements does not include only those elements but may include other elements not expressly listed or inherent to such process, method, article, or apparatus.

## Claims

1. A method of fabricating a composite component, comprising:
forming a fibrous preform (602);
performing a first densification on the fibrous preform to generate a densified fibrous preform (606);
heat treating the densified fibrous preform to form a heat treated densified fibrous preform (608);
performing a second densification on the heat treated densified fibrous preform (610); and
performing a silicon melt infiltration after densifying the heat treated densified fibrous preform to form the composite component (612).

2. The method of claim 1, wherein the first densification is performed for between 50 hours and 400 hours at between 900°F (482.2°C) and 1200°F (648.9°C).

3. The method of claim 1 or 2, wherein the heat treating is performed for between 2 hours and 20 hours at between 1300°F (704.4°C) and 2200°F (1204°C).

4. The method of any preceding claim, wherein the second densification is performed for between 50 hours and 400 hours at between 900°F (482.2°C) and 1200°F (648.9°C).

5. The method of any preceding claim, further comprising:
after the second densification and prior to the silicon melt infiltration, machining the heat treated densified fibrous preform to form a final desired part shape of the composite component.

6. The method of any preceding claim, wherein performing the first densification on the fibrous preform generates a carbon matrix within the densified fibrous preform.

7. The method of claim 6, wherein the heat treating of the densified fibrous preform generates one or more cracks in the carbon matrix.

8. The method of claim 7, wherein performing the second densification on the heat treated densified fibrous preform seals the one or more cracks in the carbon matrix, and optionally wherein sealing the one or more cracks reduces bending or warping of the composite component.

9. The method of claim 7, wherein performing the second densification on the heat treated densified fibrous preform maintains dimensional tolerances and strength of the composite component and reducing over-conversion of the carbon matrix to silicon carbide.

10. A method of forming a fibrous preform for fabricating a composite component, comprising:
forming a first ceramic particle layer over a first textile layer;
disposing a second textile layer over the first ceramic particle layer;
forming a second ceramic particle layer over the second textile layer;
disposing a third textile layer over the second ceramic particle layer;
performing a first densification on the fibrous preform to generate a densified fibrous preform;
heat treating the densified fibrous preform to form a heat treated densified fibrous preform;
performing a second densification on the heat treated densified fibrous preform; and
performing a silicon melt infiltration after densifying the heat treated densified fibrous preform to form the composite component.

11. The method of claim 10, wherein the first densification is performed for between 50 hours and 400 hours at between 900°F (482.2°C) and 1200°F (648.9°C), and/or wherein the heat treating is performed for between 2 hours and 20 hours at between 1300°F (704.4°C) and 2200°F (1204°C), and/or wherein the second densification is performed for between 50 hours and 400 hours at between 900°F (482.2°C) and 1200°F (648.9°C).

12. The method of claim 10 or 11, further comprising:
after the second densification and prior to the silicon melt infiltration, machining the heat treated densified fibrous preform to form a final desired part shape of the composite component, and/or wherein performing the first densification on the fibrous preform generates a carbon matrix within the densified fibrous preform.

13. The method of claim 12, wherein the heat treating of the densified fibrous preform generates one or more cracks in the carbon matrix.

14. The method of claim 13, wherein performing the second densification on the heat treated densified fibrous preform seals the one or more cracks in the carbon matrix, and optionally wherein sealing the one or more cracks reduces bending or warping of the composite component.

15. The method of claim 13, wherein performing the second densification on the heat treated densified fibrous preform maintains dimensional tolerances and strength of the composite component and reducing over-conversion of the carbon matrix to silicon carbide.
